# EUROPÄISCHE PATENTSCHRIFT

(11) **EP 2 145 518 B1**
(45) Veröffentlichungstag und Bekanntmachung des Hinweises auf die Patenterteilung: **24.09.2014**
(21) Anmeldenummer: 08734779.5
(22) Anmeldetag: 26.03.2008
(51) Int. Cl.: H05K 13/00

(54) **VORRICHTUNG UND VERFAHREN ZUM BEARBEITEN VON FLÄCHIGEN SUBSTRATEN, WIE ZUM BEDRUCKEN VON LEITERPLATTEN ODER DERGLEICHEN**
DEVICE AND METHOD FOR PROCESSING FLAT SUBSTRATES, AS FOR PRINTING CIRCUIT BOARDS OR THE LIKE
DISPOSITIF ET PROCÉDÉ POUR L'USINAGE DE SUBSTRATS PLANS, PAR EXEMPLE POUR L'IMPRESSION DE CARTES DE CIRCUITS IMPRIMÉS OU ANALOGUES

(30) Priorität: 13.04.2007 DE 102007017486
(43) Veröffentlichungstag der Anmeldung: 20.01.2010
(73) Patentinhaber: Ekra Automatisierungssysteme GmbH, 74357 Bönnigheim (DE)
(72) Erfinder: BAIER, Georg, 74912 Kirchhardt (DE)
(74) Vertreter: Melzer, Wolfgang
(86) Internationale Anmeldenummer: PCT/EP2008/002381
(87) Internationale Veröffentlichungsnummer: WO 2008/125186

(56) Entgegenhaltungen:
- EP-A- 0 915 643
- DE-A1- 10 117 873
- US-B1- 6 726 195

## Beschreibung

Die Erfindung betrifft eine Vorrichtung sowie ein Verfahren zum Bearbeiten von flächigen Substraten, wie zum Bedrucken von Leiterplatten oder dergleichen.

Damit ein flächiges Substrat bearbeitet werden kann, muss es in einer vorgegebenen Lage in der Vorrichtung angeordnet werden. Insbesondere ist dabei wesentlich, dass die zu bearbeitende Fläche des Substrates plan ist und keine Verwölbungen, Aufbiegungen oder dergleichen aufweist. Dies ist insbesondere bei der Bedruckung von Leiterplatten mittels üblicher Bedruckungseinrichtungen (im Siebdruckverfahren) von Bedeutung.

Typisch wird das flächige Substrat an zwei voneinander abgewandten Seitenrandbereichen mittels einer Transporteinrichtung der Vorrichtung zugeführt, dort bearbeitet und nach Bearbeitung mittels einer ähnlichen Transporteinrichtung abgeführt (vgl. z. B. DE 101 17 873 A1). Bei etwas dickeren Substraten, insbesondere Leiterplatten, die eine große Eigensteife besitzen, kann es vorkommen, dass sich die Eckenbereiche aufbiegen und/oder dass, insbesondere bei bestückten oder teilbestückten Leiterplatten eine Wölbung in Quer- oder Längsrichtung in dem zugeführten flächigen Substrat vorhanden ist. Damit die Bearbeitung, insbesondere Bedruckung erfolgen kann, sind solche Aufbiegungen oder Wölbungen zu beseitigen. Typisch wird hierzu in der Vorrichtung das zugeführte Substrat, wenn es die Bearbeitungsposition erreicht hat, von unten nach oben mittels Unterstützungen gegen randseitige Niederhalter bewegt, wobei durch den ausgeübten Druck die Wölbung bzw. Aufbiegung ausgeglichen wird. In dieser Stellung werden dann entsprechende Klemmleisten gegen die voneinander abgewandten Seitenränder bewegt, wobei die Klemmkraft ausreicht, das an sich steife Substrat zwischen sich zu halten und zwar derart, dass selbst bei einem Entfernen der Niederhalter die erwähnten Wölbungen und Ausbiegungen nicht wieder hergestellt werden. Anschließend erfolgt die Bearbeitung. beispielsweise die Bedruckung. Falls die Niederhalter aus dem Bereich des Substrates vollständig entfernt sind, kann sogar eine vollflächige Bedruckung erfolgen.

Bei dünneren Substraten mit vergleichsweise geringer Eigensteifigkeit treten die vorerwähnten Probleme nicht auf, vielmehr würde die Ausübung von Klemmkräften eine Verbiegung des Substrates zur Folge haben. Gemäß der DE 101 17 873 A1 wird das in die Bearbeitungsposition transportierte Substrat zunächst randseitig auf Abstützungen abgesetzt und vorgesehene Klemmleisten dienen im wesentlichen nicht zur Ausübung einer Klemmkraft, die ja vermieden werden soll, sondern zur seitlichen Ausrichtung und Lagehaltung. Auch hier wird dann typisch mittels von unten nach oben fahrenden Unterstützungen das flächige Substrat gestützt, kann jedoch nicht vollständig bearbeitet, insbesondere nicht über die gesamte Fläche bedruckt werden.

Es besteht daher der Wunsch, auch bei dünnen Substraten, bei denen Klemmkräfte allenfalls in nur sehr geringem Umfang, zweckmäßig überhaupt nicht, ausgeübt werden dürfen, eine ganzflächige Bearbeitung bzw. Bedruckung unter Beibehaltung der planen Anordnung zu ermöglichen.

Es ist somit Aufgabe der vorliegenden Erfindung eine Vorrichtung und ein Verfahren anzugeben, mittels denen bei flächigen Substraten eine ganzflächige Bearbeitung möglich ist, selbst wenn es sich um dünne Substrate handelt.

Die Aufgabe wird durch die Vorrichtung gemäß Anspruch 1 und durch ein Verfahren gemäß Anspruch 8 gelöst.

Die Erfindung wird durch die Merkmale der abhängigen Ansprüche weitergebildet.

Es zeigt sich, dass die Vorgehensweise gemäß der vorliegenden Erfindung nicht nur eine Bearbeitung dünner flächiger Substrate sondern auch die Bearbeitung dicker flächiger Substrate erlaubt, wenn die Klemmleisten bei dünnen Substraten lediglich Führungsfunktion und bei dicken Substraten auch Klemmfunktion ausüben können. Dies kann gegebenenfalls automatisch steuerbar sein.

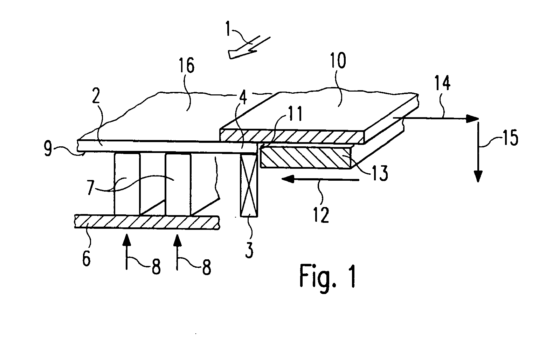

Die Erfindung wird anhand des in der einzigen Figur der Zeichnung schematisch dargestellten Ausführungsbeispiels näher erläutert.

Die Figur zeigt schematisch einen Randbereich eines gemäß einem Pfeil 1 zugeführten in einer Bearbeitungsposition der Vorrichtung befindlichen Substrates 2, wie einer Leiterplatte. Mittels einer nicht näher erläuterten Transporteinrichtung 3, die an sich bekannte Bauart besitzen kann, etwa gemäß der DE 101 17 873 A1, ist das Substrat 2 in die Bearbeitungsposition gebracht worden. Wie dargestellt liegt ein Seitenrandbereich 4 des Substrates 2 auf Transportmitteln der Transporteinrichtung 3 auf und ist in die Bearbeitungsposition auf diese Weise transportiert worden.

Es ist zu erwähnen, dass der abgewandte Seitenrandbereich des Substrats 2 in gleicher Weise gehandhabt wird, die Vorrichtung dort also spiegelsymmetrisch ausgebildet ist.

Mittels beispielsweise auf einer Kreuztischplatte 6 der Bearbeitungsvorrichtung angeordneten Unterstützungen 7, die gemäß dem Pfeil 8 aus einer Ruheposition während des Transportvorganges nach oben bewegbar sind, wird das Substrat 2 nach Anlage der Unterstützungen 7 an der Unterseite 9 des Substrats 2 insgesamt nach oben bewegt, bis der Seitenrandbereich 4 zur Anlage gegen einen Niederhalter 10 in dem Seitenrandbereich kommt. Der Seitenrand 11 des Substrates 2 in dem Seitenrandbereich 4 und eine gemäß dem Pfeil 12 bewegbare Klemmleiste 13 werden in Anlage gebracht und anschließend wird der Niederhalter 10 gemäß dem Pfeil 14 außer Anlage mit dem Substrat 2 und dem Erstreckungsbereich der Klemmleiste 13 bewegt und anschließend gemäß dem Pfeil 15 nach unten bewegt derart, dass die Oberseite 16 des Substrates 2 die am höchsten liegende Fläche ist, woraufhin der Bearbeitungsvorgang, insbesondere der Bedruckungsvorgang ausgelöst wird, wobei eine ganzflächige Bearbeitung, insbesondere Bedruckung möglich ist.

Nach Vollendung der Bearbeitung z. B. der Bedruckung wird mittels der Transporteinrichtung 3 das bearbeitete Substrat 2, nach Lösung des Eingriffes durch die Unterstützungen 7 und der Klemmleiste 13 aus der Vorrichtung zur weiteren Bearbeitung entfernt.

Es zeigt sich, dass mittels dieser Vorrichtung nicht nur, wie an sich bekannt, vergleichsweise dicke Substrate 2 bearbeitet werden können, bei denen die Klemmleisten 13 eine Klemmkraft ausüben, sondern auch vergleichsweise dünne Substrate 2, bei denen die Klemmleisten 13 geringfügige Klemmkraft, zweckmäßig gar keine Klemmkraft, ausüben dürfen und im wesentlichen lediglich zur Führung der beiden voneinander abgewandten Seitenränder 11 des Substrats 2, gegebenenfalls zur Ausrichtung bei leicht schiefen Zuschnitten dienen. Abhängig von der Eigensteifigkeit des Substrates 2, die von dessen Dicke und dessen Material wesentlich abhängt, ist die Lage und Anzahl der Unterstützung 7 bestimmt und insbesondere deren Anlagefläche gegen die Unterseite 9 des Substrats 2. Insbesondere kann eine der Unterstützungen 7 sehr nahe der Transporteinrichtung 3 angeordnet sein, derart dass sie in der Lage ist, das Substrat 2 im Bereich des Niederhalters 10, also nahe dem Seitenrandbereich 4, zu unterstützen.

Gegebenenfalls kann auch eine von der Bauart gemäß DE 101 17 873 A1 abweichende Transporteinrichtung 3 verwendet werden, derart dass von dem eigentlichen Transportmittels unabhängige Stützeinrichtungen im Randbereich 4 zusammen mit den Unterstützungen 7 gemäß dem Pfeil 8 bewegbar sind.

Das Substrat 2 mit der geringsten Eigensteifigkeit bestimmt hier die konstruktive Ausbildung solcher Stützeinrichtungen der Transporteinrichtung 3, wie Anzahl, Anordnung und Anlagefläche der Unterstützungen 7.

Die Dicke des Niederhalters 10 ist dagegen durch die Kraft bestimmt, mit der das Substrat 2 zum Ausgleich von Aufwölbungen oder Aufbiegungen, wie sie bei dicken Substraten vorkommen, erforderlich sind. Werden somit Substrate 2 bearbeitet, bei denen solche Aufwölbungen und Aufbiegungen nicht auftreten, kann der Niederhalter 10 vergleichsweise dünn ausgebildet sein. Ebenso kann die Klemmleiste 13 so ausgebildet sein, dass eine Klemmkraft nicht ausgeübt werden kann, falls ausschließlich dünne Substrate 2 zu bearbeiten sind. In diesem Fall dient die Klemmleiste 13 ausschließlich als Führung und Lagehalterung während der Bearbeitung.

Da Substrate 2 in ihrer Längsrichtung (entsprechend dem Pfeil 1) durchaus schief geschnitten sein können, ist es zweckmäßig, wenn zumindest ein Ende der Klemmleiste 13, zweckmäßig in Richtung des Pfeils 1 des hinteren Endes, pendelnd gelagert ist.

Es zeigt sich, dass mittels der erfindungsgemäß ausgebildeten Vorrichtung die Bearbeitung, insbesondere die Bedruckung, nicht nur von dünnen Substraten 2, sondern auch von dicken Substraten 2 möglich ist, bei denen die Klemmleiste 13 eine Klemmkraft in Pfeilrichtung 12 auszuüben hat, wie das eingangs geschildert worden ist. Es ist sogar möglich automatisch, abhängig von dem jeweils zugeführten Substrat 2. die Klemmleiste 13 derart zu steuern, dass sie Klemmkraft ausübt oder nicht. Es ist selbstverständlich auch möglich, abhängig von der Dicke des Substrats 2 die Hubbewegung gemäß Pfeil 8 der Unterstützungen 7 so zu bemessen, dass die Anlage der Oberseite 16 des Substrates 2 gegen den Niederhalter 10 sichergestellt ist, ohne dass Beschädigungen eintreten und die Bewegung des Niederhalters 10 gemäß den Pfeilen 14 und 15 sichergestellt bleibt. Dies kann mit Hilfe von Sensoreinrichtungen erfolgen, die die relevanten Daten, nämlich die Art des Substrates 2 hinsichtlich der Biegesteifigkeit einerseits bzw. hinsichtlich der Dicke andererseits erfassen. Selbstverständlich ist auch eine Programmsteuerung für diesen Zweck möglich und selbstverständlich ist auch eine Handjustierung als im Rahmen der vorliegenden Erfindung zu sehen.

Es zeigt sich, dass auch bei Substraten 2 geringer Eigensteifigkeit eine vollflächige Bearbeitung, insbesondere Bedruckung möglich ist.

## Patentansprüche

1. Vorrichtung für die Bearbeitung von flächigen Substraten (2), wie zu bedruckenden Leiterplatten oder dergleichen,
bei der das Substrat (2) an zwei voneinander abgewandten Seitenrandbereichen (4) auf einer Transporteinrichtung aufliegend zuführbar ist, zwecks der Bearbeitung zunächst mittels Unterstützungen (7) von unten nach oben bewegbar und in den Seitenrandbereichen (4) gegen jeweilige Niederhalter (10) drückbar ist, in dieser Lage, auf den Unterstützungen (7) ruhend an den entsprechenden Seitenrändern (11) des Substrates (2) zwischen jeweils Klemmleisten (13) klemmbar ist, woraufhin jeder Niederhalter (10) seitlich weg von dem Substrat (2) und der jeweiligen Klemmleiste (13) und ferner unter den Bereich der Oberseite (16) des so angeordneten Substrats absenkbar ist, woraufhin eine ganzflächige Bearbeitung ausführbar ist.

2. Vorrichtung nach Anspruch 1, **dadurch gekennzeichnet, dass** die Klemmkraft der Klemmleiste (13) einstellbar ist, derart dass bei Substraten (2) hoher Biegesteifigkeit hohe Klemmkräfte und bei Substraten niedriger Biegesteifigkeit entsprechend niedrige oder gar keine Klemmkräfte ausübbar sind.

3. Vorrichtung nach Anspruch 1 und 2, **dadurch gekennzeichnet, dass** die Klemmleiste (13), vorzugsweise in ihrem in Transportrichtung (1) des Substrats (2) hinteren Bereich, pendelnd gelagert ist.

4. Vorrichtung nach einem der Ansprüche 1 bis 3, **dadurch gekennzeichnet, dass** die Anzahl und Lage der Unterstützungen (7) so abhängig von der Steifigkeit des Substrates (2) bestimmt ist, dass das Substrat (2) auch nach Entfernung der Niederhalter (10) plan auf den Unterstützungen (7) aufliegt.

5. Vorrichtung nach Anspruch 4, **dadurch gekennzeichnet, dass** die Transporteinrichtung (3) der Vorrichtung im Bereich der Bearbeitungsposition so ausgerichtet ist, dass sie auf und ab bewegbare Stützeinrichtungen aufweist, derart dass das Substrat (2) im Seitenrandbereich (4) gegen den Niederhalter (10) bewegbar ist und nach dessen Entfernung in Zusammenwirken mit den Unterstützungen (7) plan liegt.

6. Vorrichtung nach einem der Ansprüche 1 bis 5, **gekennzeichnet durch** eine Einrichtung zur Einstellung der Höhe der Hubbewegung der Unterstützungen (7) abhängig von der Dicke des Substrates (2).

7. Vorrichtung nach einem der Ansprüche 1 bis 6, **dadurch gekennzeichnet, dass** eine Einrichtung vorgesehen ist, die die Klemmkraft der Klemmleiste (13) abhängig von der Eigensteife des Substrates (2) einstellt.

8. Verfahren zum Bearbeiten von flächigen Substraten (2), wie zum Bedrucken von Leiterplatten oder dergleichen,
bei dem das Substrat (2) an zwei voneinander abgewandten Seitenrandbereichen (4) mittels einer Transporteinrichtung zugeführt wird, in eine Bearbeitungsposition zunächst von unten nach oben bewegt wird, derart dass die Seitenrandbereiche (4) gegen jeweilige Niederhalter zu Anlage kommen, in dieser Lage dann an den Seitenrändern (4) des Substrates (2) jeweilige Klemmleisten zur Anlage gebracht werden, gegebenenfalls eine Klemmkraft ausüben, die Niederhalter dann seitlich weg aus dem Bereich des Substrates und der Klemmleiste heraus bewegt werden und dann unter den Bereich der Oberseite (16) des so angeordneten Substrates (2) abgesenkt werden, woraufhin dann die Bearbeitung durchgeführt wird.

9. Verfahren nach Anspruch 8, **dadurch gekennzeichnet, dass** das Substrat (2) mittels Unterstützungen (7) in die Bearbeitungsposition von unten nach oben bewegt wird, wobei die Höhe der Hubbewegung der Unterstützungen (7) abhängig von der Dicke des Substrates (2) eingestellt wird.

10. Verfahren nach Anspruch 8 oder 9, **dadurch gekennzeichnet, dass** die Klemmkraft der Klemmleiste (13) abhängig von der Eigensteife des Substrates (2) eingestellt wird.

## Claims

1. Apparatus for processing flat substrates (2), such as circuit boards to be printed or the like,
wherein the substrate (2) can be fed at two lateral edge areas (4) facing away from one another lying on a transport device, for the purpose of the processing can be initially moved from the bottom upwards by means of supports (7) and can be pressed against respective hold-downs (10) in the lateral edge areas (4), and in this position, resting on the supports (7), can be clamped at the corresponding lateral edges (11) of the substrate (2) between respective clamping bars (13), whereupon each hold-down (10) can be lowered laterally away from the substrate (2) and the respective clamping bar (13) and further below the area of the top surface (16) of the substrate thus arranged, whereupon a processing of the entire surface can be carried out.

2. Apparatus according to Claim 1, **characterised in that** the clamping force of the clamping bar (13) can be adjusted in such a way that in the case of substrates (2) having a high bending stiffness, high clamping forces can be applied, and in the case of substrates having a low bending stiffness, correspondingly low clamping forces or no clamping forces at all can be applied.

3. Apparatus according to Claim 1 and 2, **characterised in that** the clamping bar (13) is mounted in an oscillating manner, preferably in its rear area in the transport direction (1) of the substrate (2).

4. Apparatus according to one of Claims 1 to 3, **characterised in that** the number and position of the supports (7) is determined as a function of the stiffness of the substrate (2) such that the substrate (2) lies flat on the supports (7) even after removal of the hold-downs (10).

5. Apparatus according to Claim 4, **characterised in that** the transport device (3) of the apparatus is aligned in the area of the processing position such that it has support devices which can be moved up and down, in such a way that the substrate (2) can be moved in the lateral edge area (4) against the hold-down (10) and after removal of the latter lies flat in cooperation with the supports (7).

6. Apparatus according to one of Claims 1 to 5, **characterised by** a device for adjusting the extent of the lifting movement of the supports (7) as a function of the thickness of the substrate (2).

7. Apparatus according to one of Claims 1 to 6, **characterised in that** a device which adjusts the clamping force of the clamping bar (13) as a function of the inherent rigidity of the substrate (2) is provided.

8. Method for processing flat substrates (2), such as for printing circuit boards or the like,
wherein the substrate (2) is fed at two lateral edge areas (4) facing away from one another by means of a transport device, is initially moved from the bottom upwards into a processing position in such a way that the lateral edge areas (4) come to bear against respective hold-downs, in this position then respective clamping bars are brought to bear against the lateral edges (4) of the substrate (2), and optionally apply a clamping force, the hold-downs are then moved laterally away from the area of the substrate and the clamping bar and are then lowered below the area of the top surface (16) of the substrate (2) thus arranged, whereupon the processing is then carried out.

9. Method according to Claim 8, **characterised in that** the substrate (2) is moved from the bottom upwards into the processing position by means of supports (7), wherein
the extent of the lifting movement of the support (7) is adjusted as a function of the thickness of the substrate (2).

10. Method according to Claim 8 or 9, **characterised in that** the clamping force of the clamping bar (13) is adjusted as a function of the inherent rigidity of the substrate (2).

## Revendications

1. Dispositif de traitement de substrats plats (2), tels que l'impression de cartes de circuits ou analogues,
dans lequel le substrat (2) peut être amené au niveau de deux régions formant bords latéraux (4), opposées l'une à l'autre, en étant supporté par un moyen de transport, dans lequel en vue du traitement ledit substrat peut être déplacé de bas en haut tout d'abord au moyen de supports (7) et être pressé dans les régions formant bords latéraux (4) contre des éléments d'appui respectifs (10) puis dans cette position être serré, tout en reposant sur les supports (7), à chaque fois entre des baguettes de serrage (13) au niveau des bords latéraux respectifs (11) du substrat (2), chaque élément d'appui (10) pouvant alors être abaissé latéralement afin d'être écarté du substrat (2) et de la baguette de serrage respective (13) puis amené sous la région du côté supérieur (16) du substrat ainsi disposé, afin de pouvoir effectuer un traitement sur une grande surface.

2. Dispositif selon la revendication 1, **caractérisé en ce que** la force de serrage de la baguette de serrage (13) est réglable de telle sorte que, dans le cas de substrats (2) de résistance élevée à la flexion, des forces de serrage élevées peuvent être exercées et, dans le cas de substrats de faible résistance à la flexion, de façon correspondante, des forces de serrage faibles ou même nulles sont exercées.

3. Dispositif selon les revendications 1 et 2, **caractérisé en ce que** la baguette de serrage (13), de préférence dans sa région arrière par référence à la direction de transport (1) du substrat (2), est montée de façon flottante.

4. Dispositif selon l'une des revendications 1 à 3, **caractérisé en ce que** le nombre et la position des supports (7) sont déterminés en fonction de la rigidité du substrat (2) et **en ce que** le substrat (2) repose à plat sur les supports (7) même après que les éléments d'appui (10) ont été retirés.

5. Dispositif selon la revendication 4, **caractérisé en ce que** le moyen de transport (3) du dispositif est aligné dans la zone de la position de traitement de telle façon qu'il comporte des moyens de support mobiles vers le haut et vers le bas, de telle sorte que le substrat (2) peut se déplacer vers l'élément d'appui (10) dans la région formant bords latéraux (4), et repose à plat en coopération avec les supports (7) après que l'élément d'appui (10) a été retiré.

6. Dispositif selon l'une des revendications 1 à 5, **caractérisé par** un moyen de réglage de la hauteur du mouvement d'élévation des supports (7) en fonction de l'épaisseur du substrat (2).

7. Dispositif selon l'une des revendications 1 à 6, **caractérisé en ce qu'**il est prévu un moyen qui règle la force de serrage de la baguette de serrage (13) en fonction de la rigidité propre du substrat (2).

8. Procédé de traitement de substrats plats (2), tel que l'impression de cartes de circuits imprimés ou analogues,
dans lequel le substrat (2) est amené au niveau de deux régions formant bords latéraux (4), opposées l'une à l'autre, à l'aide d'un moyen de transport, dans lequel ledit substrat est tout d'abord déplacé de bas en haut jusque dans une position de traitement de telle sorte que les régions formant bords latéraux (4) viennent en appui contre des éléments d'appui respectifs puis, dans cette position, des baguettes de serrage sont amenées en appui sur les bords latéraux (4) du substrat (2), en exerçant le cas échéant une force de serrage, les éléments d'appui étant ensuite écartés latéralement de la région du substrat et de la baguette de serrage, puis sont abaissés sous la région du côté supérieur (16) du substrat (2) ainsi disposé afin d'effectuer le traitement.

9. Procédé selon la revendication 8, **caractérisé en ce que** le substrat (2) est déplacé par des supports (7) de bas en haut vers la position de traitement, la hauteur du mouvement d'élévation du support (7) étant réglée en fonction de l'épaisseur du substrat (2).

10. Procédé selon l'une quelconque des revendications 8 ou 9, **caractérisé en ce que** la force de serrage de la baguette de serrage (13) est réglée en fonction de la rigidité propre du substrat (2).
